# FASCICULE DE BREVET EUROPEEN

(11) **EP 3 172 836 B1**
(45) Date de publication et mention de la délivrance du brevet: **06.05.2020**
(21) Numéro de dépôt: 15739639.1
(22) Date de dépôt: 23.07.2015
(51) Int. Cl.: H03F 1/08, H03F 1/30, H03F 1/32, H03F 3/181

(54) **ETAGE D'ENTRÉE D'UN AMPLIFICATEUR ET AMPLIFICATEUR CORRESPONDANT**
EINGANGSSTUFE EINES VERSTÄRKERS UND ENTSPRECHENDER VERSTÄRKER
INPUT STAGE OF AN AMPLIFIER AND CORRESPONDING AMPLIFIER

(30) Priorité: 23.07.2014 FR 1457117
(43) Date de publication de la demande: 31.05.2017
(73) Titulaire: Devialet, 75001 Paris (FR)
(72) Inventeur: CALMEL, Pierre-Emmanuel, F-78150 Le Chesnay (FR); HUFFENUS, Alexandre, F-38000 Grenoble (FR)
(74) Mandataire: Lavoix
(86) Numéro de dépôt international: PCT/EP2015/066946
(87) Numéro de publication internationale: WO 2016/012571

(56) Documents cités:
- WO-A1-2011/107671
- US-A1- 2007 135 868
- US-A1- 2013 002 225
- US-A1- 2014 184 339
- "DUAL-CURRENT SINK FOR DIGITAL-TO-ANALOG CONVERTER", IBM TECHNICAL DISCLOSURE BULLETIN,, vol. 30, no. 3, 1 août 1987 (1987-08-01), pages 1110-1111, XP001404379,

## Description

La présente invention concerne un étage d'entrée d'un amplificateur haute fidélité à haute linéarité et faible taux de distorsion selon la revendication 1. L'étage d'entrée de l'amplificateur comprenant :
- une entrée pour le signal numérique à convertir ;
- une sortie en tension pour la tension convertie ;
- un convertisseur numérique-analogique dont l'entrée forme l'entrée pour le signal numérique à convertir, le convertisseur numérique-analogique disposant d'une borne de signal ;
- une résistance de conversion du courant en tension agencée entre la sortie en tension et un potentiel de référence ; et
- un convertisseur courant-tension à sortie en tension, agencé entre la borne de signal et la sortie en tension, le convertisseur courant-tension comportant un transistor tel que la grille du transistor est reliée à une source de tension, le drain du transistor est relié à une source de courant et la source du transistor est reliée au convertisseur numérique-analogique, la source de courant générant un courant continu.

Un tel étage d'entrée trouve son application en particulier dans un amplificateur haute fidélité à haute linéarité.

Il est courant, dans un tel amplificateur, d'utiliser en entrée, un convertisseur numérique-analogique tel que le composant PCM 1792 de la société Texas Instruments. Ce convertisseur numérique-analogique possède une sortie en courant, de sorte que le signal analogique est modulé en intensité.

Dans la mesure où l'étage d'amplification placé en aval utilise en entrée une tension modulée, il convient de disposer un convertisseur courant-tension entre le convertisseur numérique-analogique et l'étage d'amplification proprement dit.

Les convertisseurs numérique-analogique à sortie en courant sont particulièrement appréciés pour le très faible niveau de distorsion harmonique qu'ils peuvent atteindre. La difficulté consiste à exploiter les qualités de tels convertisseurs numérique-analogique via un étage de conversion courant-tension qui n'impacte pas lui-même les performances du convertisseur numérique-analogique.

Les sources de courant contenues dans un tel convertisseur numérique-analogique sont connectées à une ou plusieurs sorties reliées à une masse virtuelle ou encore connectées entre une masse et une ou plusieurs sorties reliées à une masse virtuelle. De telles connexions sont traditionnellement réalisées au moyen d'un montage à amplificateur opérationnel.

Une masse virtuelle est un potentiel fixe.

De cette manière, tous les transistors du convertisseur numérique-analogique fonctionnent à courant et tension constants, donc de façon optimale, quelque soit la modulation du signal de sortie.

Afin de préserver cette absence de distorsion, les convertisseurs courant-tension placés en aval peuvent également, dans une implémentation différente de celle du montage à amplificateur opérationnel, comporter des étages spécifiques, dits « à grille commune » à base de transistors MOSFET (de l'anglais *Métal Oxide Semiconductor Field Effect Transistor*) ou dits « à base commune » à base de transistors bipolaires. De tels étages à grille ou base commune fonctionnent en boucle ouverte.

Ce type de montage comprenant des transistors à base ou grille commune, plus communément appelé « cascode », est décrit dans le document WO 2011/107671. Dans ce document, les transistors des étages à base ou grille commune sont reliés au niveau de leur source à des sources de courant.

Au moins l'une de ces sources de courant est propre à imposer un courant de polarisation. Les autres sources de courant sont notamment propres à annuler la composante continue provenant du convertisseur numérique-analogique de sorte que seule la composante variable provenant du convertisseur numérique-analogique soit convertie en tension par le convertisseur courant-tension.

L'étage cascode permet de garantir que les sources de courant ne présentent pas de variations de tension à leurs bornes lorsque la tension au niveau de la sortie en tension du convertisseur courant-tension varie, et ce même lorsque cette tension varie de plusieurs dizaines de Volt.

De plus, un tel étage cascode impose un potentiel constant à la sortie en courant du convertisseur numérique-analogique, quelle que soit la tension au niveau de la sortie en tension du convertisseur courant-tension.

Par conséquent, la qualité de l'information contenue dans le courant issu du convertisseur numérique-analogique est conservée lorsque ce courant est converti en tension par la résistance.

Cependant, ces sources de courant sont, notamment, à l'origine d'une consommation de courant importante et à l'origine d'un échauffement de l'étage d'entrée.

Un but de l'invention est donc de proposer une solution pour minimiser l'échauffement de l'étage d'entrée..

A cet effet, l'invention a pour objet un étage d'entrée d'un amplificateur haute fidélité à haute linéarité et faible taux de distorsion du type précité, dans lequel la source du transistor est reliée uniquement à la borne de signal du convertisseur numérique-analogique.

Suivant des modes particuliers de réalisation, le convertisseur comporte l'une ou plusieurs des caractéristiques suivantes :
- le convertisseur numérique-analogique est propre à générer un courant comprenant une composante continue et une composante fixe, et la source de courant est propre à fournir un courant égal à la composante continue du courant généré par le convertisseur numérique-analogique ;
- le convertisseur numérique-analogique est à absorption de courant ;
- l'étage d'entrée est réalisé sur un circuit intégré.

L'invention a également pour objet un amplificateur haute fidélité à haute linéarité et faible taux de distorsion, comportant un étage d'entrée du type précité, et un étage d'amplification, connecté en série à l'étage d'entrée.

L'invention sera mieux comprise à la lecture de la description qui va suivre, donnée uniquement à titre d'exemple et faite en se référant aux dessins sur lesquels :
- la figure 1 est une vue schématique d'un amplificateur haute fidélité comprenant un étage d'entrée selon l'invention ;
- la figure 2 est un schéma électrique d'un étage d'entrée de l'amplificateur de la figure 1 selon l'invention.

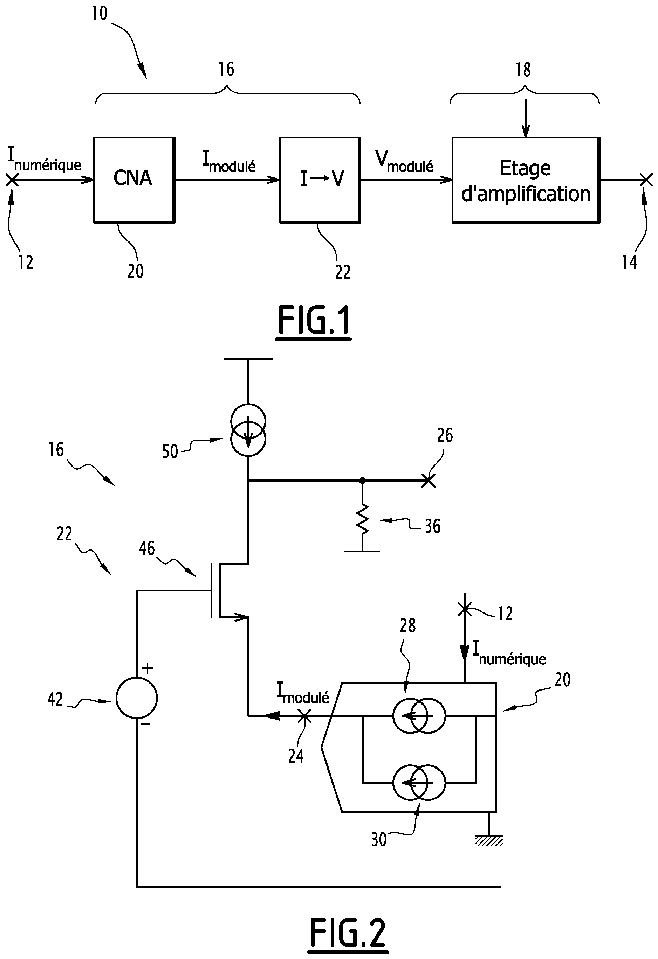

L'amplificateur 10, représenté schématiquement sur la figure 1, est un amplificateur haute fidélité propre à recevoir sur une entrée 12 un signal numérique et à produire sur une sortie 14 un signal analogique amplifié.

Comme connu en soi, l'amplificateur 10 comporte un étage d'entrée 16 assurant la conversion du signal numérique d'entrée en un signal analogique de sortie modulé en tension, ainsi qu'un étage d'amplification 18, assurant la fourniture d'une puissance suffisante pour la charge placée en aval, à savoir un ou plusieurs hauts parleurs. Il s'agit de préférence d'un étage d'amplification de classe A.

L'étage d'entrée 16 comporte un convertisseur numérique-analogique 20 dont l'entrée est reliée à l'entrée 12 de l'amplificateur pour recevoir un signal numérique I_{numérique}. Ce convertisseur numérique-analogique est propre à fournir un signal analogique modulé en courant I_{modulé}. Le convertisseur numérique-analogique est, par exemple, un PCM 1792 de la société Texas Instruments.

Le courant I_{modulé} comporte une composante variable et une composante fixe.

La sortie du convertisseur numérique-analogique 20 est reliée à un convertisseur courant-tension 22 selon l'invention.

Ce convertisseur courant-tension 22 est propre à fournir une tension modulée V_{modulé} avec un gain en tension, à partir du courant modulé I_{modulé} produit par le convertisseur numérique-analogique 20.

La sortie du convertisseur courant-tension 22 est reliée à l'entrée de l'étage d'amplification 18, comme connu en soi.

La figure 2 illustre l'étage d'entrée 16 de l'amplificateur de la figure 1.

Sur cette figure 2, le convertisseur numérique-analogique 20 est relié en entrée à l'entrée 12 de l'amplificateur 10 et présente une borne de signal 24 pour générer un courant I_{modulé} comportant une composante continue et une composante fixe. Le convertisseur numérique-analogique 20 est également relié à une masse.

Le convertisseur courant-tension 22 est relié à la borne de signal 24 du convertisseur numérique-analogique 20 et présente une sortie en tension 26 propre à être reliée directement à l'étage d'amplification 18.

Le convertisseur numérique-analogique 20 est schématisé sur la figure 2 par deux sources de courant 28 et 30. Plus précisément, la première source de courant 28 est propre à générer la composante continue du courant I_{modulé} en sortie du convertisseur numérique-analogique 20. La deuxième source de courant 30 est, quant à elle, propre à générer la composante variable du courant I_{modulé} en sortie du convertisseur numérique-analogique 20.

Sur la figure 2, le convertisseur numérique-analogique 20 est à absorption de courant et forme un puits de courant, couramment désigné par « sink » en anglais. L'expression « à absorption de courant » signifie que le courant I_{modulé} au niveau de la borne de signal 24 du convertisseur numérique-analogique 20 est absorbé, c'est-à-dire que si le sens conventionnel du courant illustré par la flèche représentant le courant I_{modulé} sur la figure 2 est dirigé vers le transistor 46 et non vers le convertisseur numérique-analogique 20, le courant I_{modulé} est toujours négatif.

Le convertisseur numérique-analogique 20 est, par exemple, un convertisseur AD 1955 de la société Analog Devices.

Le convertisseur courant-tension 22 comporte une résistance de conversion 36 dont une borne est reliée à la sortie en tension 26, et dont l'autre borne est reliée à un potentiel de référence.

La résistance 36 est propre à convertir le courant I_{modulé} en sortie du convertisseur numérique-analogique 20 en une tension V_{modulée}.

Le convertisseur courant-tension 22 comporte, en outre, au moins un transistor 46 relié au niveau de sa source au convertisseur numérique-analogique 22. Sur la figure 2, seul un transistor 46 est représenté, toutefois le convertisseur courant-tension 22 peut comporter plusieurs transistors 46.

Le transistor 46 forme un étage cascode ou à grille ou base commune de l'étage d'entrée 16.

Le transistor 46 est, par exemple, un transistor MOSFET.

Le convertisseur courant-tension 22 comporte, également, une source de tension 42 reliée à la grille du transistor 46 de la figure 2.

Le convertisseur courant-tension 22 comporte, en outre, une troisième source de courant 50 reliée au drain du transistor 46.

La troisième source de courant 50 est propre à générer un courant continu de polarisation dans le circuit électrique de l'étage d'entrée 16.

Comme visible sur la figure 2, le convertisseur courant-tension 22 comporte une seule source de courant 50 et la source du transistor 46 est reliée directement et uniquement à la sortie en courant du convertisseur numérique-analogique 20. En particulier, aucune source de courant n'est connectée entre le transistor 46 et le convertisseur numérique-analogique 20..

La source de courant 50 est telle que le courant généré par la source de courant 50 est égal au courant généré par la source de courant 28 du convertisseur numérique-analogique 20, donc égal à la composante continue du courant I_{modulé}, ceci afin d'avoir dans le transistor 46 un courant non nul quel que soit la valeur du signal d'entrée numérique. En effet, la composante variable du courant I_{modulé} est toujours inférieure en valeur absolue à la composante constante du courant I_{modulé}, de sorte que la valeur de ce dernier soit toujours du même signe.

Par exemple, si la composante continue du courant I_{modulé} est égal à 3 mA et la composante variable de ce courant I_{modulé} est de 2 mA, alors le courant généré par la source de courant 50 est fixé à 3 mA.

Le convertisseur numérique-analogique 20 et le convertisseur courant-tension 22 sont réalisés sur un même circuit intégré, comprenant un substrat semi-conducteur, par exemple, à base de silicium. Le circuit intégré est, par exemple, du type ASIC (acronyme de l'anglais *Application-Specific Integrated Circuit*)*.*

Ainsi, un tel étage d'entrée 16 d'amplificateur permet de réduire le nombre de sources de courant du convertisseur courant-tension 22 en exploitant les caractéristiques du convertisseur numérique-analogique 20.

Ainsi, un tel circuit comporte moins de composants et est donc plus compacte à réaliser sur circuit intégré et donc moins coûteux.

De plus, la diminution du nombre de sources de courant diminue les risques d'échauffement du circuit et permet d'économiser de l'énergie.

## Revendications

1. Etage d'entrée (16) d'un amplificateur (10) comportant :
- une entrée (12) pour un signal numérique à convertir ;
- une sortie en tension (26) pour une tension convertie ;
- un convertisseur numérique-analogique (20) dont l'entrée forme l'entrée (12) pour un signal numérique à convertir, le convertisseur numérique-analogique (20) disposant d'une borne de signal (24) de sortie pour générer un courant (I_{modulé}) ;
- une résistance (36) de conversion du courant en tension reliée à la sortie en tension (26) et à un potentiel de référence ; et
- un convertisseur courant-tension (22) à sortie en tension, relié entre la borne de signal (24) de sortie et la sortie en tension (26), le convertisseur courant-tension (22) comportant un transistor (46) tel que la grille du transistor (46) est reliée à une source de tension (42), le drain du transistor (46) est relié à une source de courant (50) et la source du transistor (46) est reliée au convertisseur numérique-analogique (20), la source de courant (50) générant un courant continu ;
**caractérisé en ce que** la source du transistor (46) est reliée directement et uniquement à la borne de signal (24) de sortie du convertisseur numérique-analogique (20) et **en ce que** le convertisseur numérique-analogique (20) est propre à générer le courant (I_{modulé}) comprenant une composante continue et une composante variable, la source de courant (50) étant propre à fournir un courant égal à la composante continue du courant (I_{modulé}) généré par le convertisseur numérique-analogique (20), le convertisseur numérique-analogique (20) étant relié entre un potentiel fixe et la source du transistor (46).

2. Etage d'entrée (16) selon la revendication 1, **caractérisé en ce que** le convertisseur numérique-analogique (20) est à absorption de courant.

3. Etage d'entrée (16) selon la revendication 1 ou 2, **caractérisé en ce que** l'étage d'entrée (16) est réalisé sur un circuit intégré.

4. Amplificateur (10) **caractérisé en ce qu'**il comporte un étage d'entrée (16) selon l'une quelconque des revendications 1 à 3, et un étage d'amplification (18), connecté en série à l'étage d'entrée (16).

## Patentansprüche

1. Eingangsstufe (15) eines Verstärkers (10), umfassend:
- einen Eingang (12) für ein digitales Signal, das umgewandelt werden soll;
- einen Ausgang unter Spannung (26) für eine umgewandelte Spannung;
- einen Digital-Analog-Wandler (20), dessen Eingang den Eingang (12) für ein digitales Signal, das umgewandelt werden soll, bildet; wobei der Digital-Analog-Wandler (20) über einen Ausgangssignalanschluss (24) verfügt, um einen Strom (I_{moduliert}) zu erzeugen;
- einen Widerstand (36) zur Umwandlung des Stroms in Spannung, der mit dem Ausgang unter Spannung (26) und einem Referenzpotenzial verbunden ist; und
- einen Strom-Spannungs-Wandler (22) am Ausgang unter Spannung, der zwischen dem Ausgangssignalanschluss (24) und dem Ausgang unter Spannung (26) verbunden ist, wobei der Strom-Spannungs-Wandler (22) einen Transistor (46) umfasst, so dass das Gitter des Transistors (46) mit einer Spannungsquelle (42) verbunden ist, der Drain des Transistors (46) mit einer Stromquelle (50) verbunden ist und die Quelle des Transistors (46) mit dem Digital-Analog-Wandler (20) verbunden ist, wobei die Stromquelle (50) einen Gleichstrom generiert;
**dadurch gekennzeichnet, dass** die Quelle des Transistors (46) direkt und ausschließlich mit dem Ausgangssignalanschluss (24) des Digital-Analog-Wandlers (20) verbunden ist, und dadurch, dass der Digital-Analog-Wandler (20) geeignet ist, den Strom (I_{moduliert}), umfassend einen kontinuierlichen Bestandteil und einen variablen Bestandteil, zu generieren, wobei die Stromquelle (50) geeignet ist, einen Strom gleich der kontinuierlichen Komponente des Stroms (I_{moduliert}) zu liefern, generiert vom Digital-Analog-Wandler (20), wobei der Digital-Analog-Wandler (20) zwischen einem festen Potenzial und der Quelle des Transistors (46) verbunden ist.

2. Eingangsstufe (16) nach Anspruch 1, **dadurch gekennzeichnet, dass** der Digital-Analog-Wandler (20) mit Stromaufnahme ist.

3. Eingangsstufe (16) nach Anspruch 1 oder 2, **dadurch gekennzeichnet, dass** die Eingangsstufe (16) auf einem Schaltkreis durchgeführt ist.

4. Verstärker (10), **dadurch gekennzeichnet, dass** er eine Eingangsstufe (16) nach einem der Ansprüche 1 bis 3 und eine Verstärkungsstufe (18) umfasst, die in Reihe in der Eingangsstufe (16) verbunden ist.

## Claims

1. An input stage (16) of an amplifier (10) comprising:
- an input (12) for a digital signal to be converted;
- a voltage output (26) for a converted voltage;
- a digital-to-analog converter (20), the input of which forms the input (12) for a digital signal to be converted, the digital-to-analog converter (20) having an output signal terminal (24) for generating a current (I_{modulated});
- a resistance (36) for converting the current into a voltage, connected to the voltage output (26) and to a reference potential; and
- a current-voltage converter (22) with a voltage output, connected between the output signal terminal (24) and the voltage output (26), the current-voltage converter (22) comprising a transistor (46) such as the gate of the transistor (46) is connected to a voltage source (42), the drain of the transistor (46) is connected to a current source (50) and the source of the transistor (46) is connected to the digital-to-analog converter (20), the current source (50) generating a continuous current;
**characterized in that** the source of the transistor (46) is directly and exclusively connected to the output signal terminal (24) of the digital-to-analog converter (20) and **in that** the digital-to-analog converter (20) is able to generate the current (I_{modulated}) comprising a continuous component and a variable component, the current source (50) being able to provide a current equal to the continuous component of the current (I_{modulated}) generated by the digital-to-analog converter (20), the digital-to-analog converter (20) being connected between a fixed potential and the source of the transistor (46).

2. The input stage (16) according to claim 1, **characterized in that** the digital-to-analog converter (20) is with current absorption.

3. The input stage (16) according to claim 1 or 2, **characterized in that** the input stage (16) is made on an integrated circuit.

4. An amplifier (10) **characterized in that** it comprises an input stage (16) according to any one of claims 1 to 3, and an amplification stage (18), connected in series with the input stage (16).
